Europäisches Patentamt

European Patent Office

Office européen des brevets

(19)

(11) EP 0 706 141 A1

## (12) DEMANDE DE BREVET EUROPEEN

(43) Date de publication:
**10.04.1996 Bulletin 1996/15**

(51) Int Cl.⁶: **G06F 17/50**

(21) Numéro de dépôt: **95401930.3**

(22) Date de dépôt: **22.08.1995**

(84) Etats contractants désignés:
**DE FR GB IT NL SE**

(30) Priorité: **24.08.1994 FR 9410260**

(71) Demandeur: **BULL S.A.**
**F-78430 Louveciennes (FR)**

(72) Inventeur: **Guignet, Jean Bruce**
**F-78340 Les Clayes Sous Bois (FR)**

(54) **Outil produisant de façon automatique une spécification abstraite d'un système physique et procédé de réalisation d'un système physique utilisant un tel outil**

(57)    A partir du descriptif concret GND qui contient les éléments d'un système physique et les connexions entre ces éléments, l'outil déduit automatiquement le descriptif fonctionnel VHD de ce système à l'aide d'un moteur d'inférence MOTINF et d'un filtre FILTER.

Le moteur d'inférence sélectionne des règles dans une bibliothèque GRL et des fonctions programmées pour les charger dans le filtre. Ainsi chargé, le filtre regroupe les éléments du descriptif GND, réalisant ainsi une abstraction structurelle du descriptif GND, et parallèlement élabore un descriptif fonctionnel en langage formel de chaque regroupement. L'accumulation des descriptifs fonctionnels ainsi obtenu donne le descriptif fonctionnel VHD du système.

EP 0 706 141 A1

## Description

L'invention est relative à un outil qui produit de façon automatique une spécification abstraite d'un système physique. La spécification abstraite d'un système physique est une description du comportement fonctionnel de ce système. L'invention concerne également un procédé utilisant cet outil pour réaliser un système physique à partir d'une spécification abstraite. L'invention est particulièrement intéressante lorsque le système physique est un circuit électronique complexe tel qu'un circuit électrique intégré.

Un circuit électrique intégré à haute densité, couramment connu sous le nom de VLSI, est constitué de milliers de transistors. Un tel circuit est réalisé à partir d'une spécification abstraite, traduite dans un langage formel pour en permettre un traitement systématique. Un système de CAO (conception assistée par ordinateur) transforme la spécification abstraite en un descriptif concret de tous les éléments du circuit et de leurs interconnexions. Les éléments du circuit sont alors constitués de transistors appartenant à une technologie connue telle que l'une des technologies CMOS, BICMOS, bipolaire ou AsGa. Ce descriptif concret est souvent appelé liste de connectique (netlist) par l'homme de l'art. Cette liste de connectique est ensuite convertie en une description informatique de masques, supportée par exemple par une bande magnétique. Des techniques photographiques permettent ensuite de reporter la description physique des transistors sur un substrat matériel.

La réalisation d'un circuit comprend une chaîne directe constituée d'une succession d'étapes de raffinement convertissant la spécification abstraite en fonctions logiques, puis ces fonctions logiques en portes logiques, et enfin ces portes logiques en transistors. Ces transistors sont enfin définis par leurs formes géométriques et leurs compositions chimiques telles que matérialisées dans un corps semi-conducteur qui réalise ainsi le circuit spécifié. Après réalisation, on teste le circuit pour s'assurer que celui-ci répond bien à la spécification abstraite d'origine.

Cependant, pour s'assurer de façon complète de la bonne conformité du circuit à la spécification abstraite, il est nécessaire de modéliser, dans la procédure de test, tous les cas possibles de fonctionnement du circuit, ce qui devient rapidement difficile, voire impossible pour des circuits complexes. D'autre part, la détection d'éventuelles erreurs de fonctionnement après le dernier stade de concrétisation entraîne des coûts élevés causés par la nécessité de fabriquer de nouveaux masques, de jeter au rebut des matériaux semi-conducteurs inutilisables.

L'invention a pour objet d'éviter ces inconvénients en donnant la possibilité d'évaluer le comportement fonctionnel d'un système physique complexe.

Cette possibilité est obtenue grâce à un outil produisant automatiquement, suivant des procédures programmées, une spécification abstraite définissant le comportement fonctionnel d'un système physique à partir d'un descriptif concret définissant la structure de ce système. Cet outil comprend des moyens pour associer des données sous forme d'objets aux éléments du descriptif concret, des moyens pour associer des valeurs d'attribut structurel de ces objets aux connexions physiques de ces éléments avec d'autres éléments du descriptif concret, des moyens pour regrouper les objets ainsi obtenus en objets représentant chacun un composant physique constitué des éléments du descriptif concret associés aux objets regroupés dans ledit objet, des moyens pour associer une valeur d'attribut structurel dudit objet à chaque connexion physique d'un élément avec un élément extérieur au composant physique représenté par ledit objet. Cet outil comprend de plus des moyens pour doter ledit objet d'un attribut fonctionnel dont la valeur est une chaîne de caractères traduisant en langage formel, le comportement fonctionnel du composant physique associé au dit objet, des moyens pour réutiliser de façon automatique les moyens précédemment décrits en remplaçant les objets regroupés par des nouveaux objets, et ceci jusqu'à ne plus pouvoir regrouper d'objets, et des moyens pour concatèner les valeurs d'attributs fonctionnels des objets résultants pour produire la spécification abstraite définissant le comportement fonctionnel du système physique.

Ainsi, la génération de chaque nouvel objet s'accompagne de l'adjonction d'une séquence de langage formel dans le texte d'une description initialement vide.

Les données, associées sous forme d'objets aux éléments du descriptif concret, sont alors rangées de façon structurée sur un support physique d'enregistrement, adapté à leur traitement systématique par les procédures programmées d'un ordinateur sans intervention humaine. De cette façon, une spécification abstraite est produite automatiquement sur un autre support physique d'enregistrement, exploitable à son tour par un ordinateur.

Les moyens pour regrouper les objets et y associer des valeurs d'attributs structurel et des valeurs d'attributs fonctionnels peuvent être mis en oeuvre selon différents modes.

Selon un premier mode de mise en oeuvre de l'invention, l'outil comprend des moyens pour associer à chaque élément concret de cette structure une donnée sous forme d'objet, des moyens pour associer une valeur d'attribut structurel de cet objet à chaque connexion physique de cet élément avec un autre élément concret de la structure, des moyens pour regrouper à l'aide de règles les objets ainsi obtenus en objets représentant chacun un composant physique constitué des éléments concrets de la structure, associés aux objets regroupés dans ledit objet, des moyens pour associer à l'aide de ces même règles, une valeur d'attribut structurel du dit objet à chaque connexion physique d'un élément avec un élément extérieur au composant physique représenté par le dit objet. L'outil comprend aussi des moyens pour doter à l'aide de ces même règles, ledit objet d'un attribut fonctionnel dont la valeur est une chaîne de caractères traduisant en langage formel, le comportement fonctionnel du composant physique représenté par ledit objet, des moyens actionnant de façon automatique les moyens précédemment décrits jusqu'à épuisement des règles en remplaçant les objets regroupés par les objets les regroupant, ces derniers étant alors considérés comme nouveaux objets à regrouper, et des moyens pour concatèner les valeurs d'attributs fonctionnels des objets restants pour produire la spécification abstraite définissant le comportement fonctionnel du système physique.

Ainsi, les composants du système sont progressivement construits en suivant des règles de reconnaissance d'objets.

Il peut aussi exister des composants, connus par les propriétés fonctionnelles qu'ils possèdent dans une technologie donnée et dont résulte de façon systématique leur forme structurelle. Ici encore, réécrire l'intégralité des règles intervenant dans ces composants, devient rapidement fastidieux et source d'erreurs, de plus cela nécessite de faire un inventaire exhaustif de tous les composants possibles, l'être humain n'est alors pas à l'abri d'un éventuel oubli.

C'est pourquoi, selon un autre mode de mise en oeuvre de l'invention, l'outil comprend des moyens pour regrouper des ensembles d'objets élémentaires en objets composants, à l'aide de fonctions programmées qui adjoignent à chaque objet composant un ensemble d'un ou plusieurs objets complémentaires constitués des autres ensembles de l'objet composant, cette adjonction étant conditionnée par une propriété d'agencement structurel commune à ces ensembles, à l'objet composant et à chaque objet complémentaire. L'outil comprend encore des moyens pour doter l'objet composant d'un attribut fonctionnel dont la valeur est une fonction du ou des objets complémentaires, cette fonction étant déterminée par la propriété d'agencement structurel commune.

Les mécanismes, résultant de l'interprétation du formalisme des règles de production par un moteur d'inférence, pourraient être mis en oeuvre par des procédures programmées inscrites dans l'outil. Une telle mise en oeuvre aurait l'inconvénient de lier l'expression des règles à une technologie prédéterminée de réalisation de circuits électriques. Elle serait donc peu adaptée à la diversité et à l'évolution de ces technologies de réalisation.

Aussi, pour que différents utilisateurs qui emploient des technologies distinctes, puissent exploiter cet outil selon chaque cas particulier, est il intéressant de le rendre paramétrable par un fichier de règles extérieur aux procédures programmées.

Une composante intéressante de l'invention consiste à utiliser un langage orienté objet pour traiter des données structurées en objets . Chaque règle constitue alors un objet référencé par un nom suivi d'une série d'attributs. Les structures visibles d'une règle sont analogiquement équivalentes aux structures internes telles qu'elles sont manipulées, en tant qu'objets, par les procédures programmées.

C'est ainsi par exemple qu'une règle, dite règle de production est constituée d'au moins deux objets, une partie conditionnelle et une partie actionnelle. La partie conditionnelle se réfère elle-même à des objets pour déclencher la partie actionnelle. La partie actionnelle produit alors des objets qui sont réutilisables dans la partie conditionnelle d'autres règles.

Les règles, après être lues et interprétées par une procédure programmée, sont considérées comme des données objet par les procédures programmées de l'outil et manipulées en tant que tel. Ceci permet une grande souplesse pour adapter ou créer des règles appropriées à une technologie donnée, il suffit alors de modifier les attributs d'objets existants ou de créer de nouveaux objets.

D'autre part, les éléments structurels du système physique constituent des objets analogiquement équivalents à des données objet traitées par les procédures programmées de l'outil. Le fait que les objets produits par les règles, à partir des objets donnés, puissent être à leur tour réutilisés de façon automatique dans d'autres règles, en tant qu'objets donnés, permet leur traitement sur un mode hiérarchique et de façon cumulative.

Selon un autre aspect de réalisation de l'invention, les objets structurels, représentant le système physique, sont sélectionnés à partir des règles par un dispositif de filtrage mettant en oeuvre des mécanismes d'essais erreurs avec retour arrière (backtracking).

Pour cela, ces mécanismes comprennent essentiellement un filtre à travers lequel s'exécute une première action consistant à transformer les données d'un fichier contenant le descriptif structurel du circuit réalisé, au moyen de règles de production, issues d'un fichier de règles. Les règles sont déclenchées par un moteur d'inférence. Le filtre est caractérisé en ce que, simultanément à cette première action, s'exécute une deuxième action consistant à produire un fichier de données exprimant le comportement fonctionnel des données transformées.

Selon un autre aspect de réalisation de l'invention, la partie conditionnelle d'une règle comporte un modèle constitué de la combinaison d'objets OBJM dont les valeurs d'attributs sont des variables initialement libres, le système physique étant constitué d'une combinaison d'objets OBJ dont les valeurs d'attributs sont des constantes, les variables sont instanciées aux constantes pour les attributs des objets OBJM détectés équivalents aux attributs des objets OBJ par le dispositif de filtrage. Les valeurs ainsi obtenues sont propagées dans l'ensemble de la règle par un mécanisme d'unification des variables.

Les règles constituent donc des objets donnés. Il est cependant nécessaire à l'utilisateur humain d'écrire ces règles en fonction de la technologie qu'il exploite et des nouveaux composants qu'il conçoit. Or, il dispose pour cela d'éléments connus. Réécrire l'intégralité des règles intervenant dans les composants, à complexité croissante, devient rapidement fastidieux et source d'erreurs.

Pour palier ce problème, une composante intéressante de l'invention consiste en un outil de construction de règles qui génère automatiquement le modèle d'un composant connu à partir de la liste de connectique LCO de ce composant. L'outil génère également automatiquement la description formelle du comportement fonctionnel de ce composant. L'utilisateur humain est ainsi libéré de devoir reconsidérer la structure du composant connu qu'il intègre dans son nouveau système physique.

L'invention concerne également un procédé industriel de réalisation de système physique dans lequel une chaîne de retour comprend une phase d'abstraction, établissant de façon automatique, à l'aide d'une machine, une spécification abstraite à partir du produit résultant de l'une des étapes de la chaîne directe de réalisation du système physique.

Un tel procédé de réalisation comporte une phase de report dans la matière dont est constitué le système physique, d'un ensemble structuré d'éléments défini par un descriptif concret DESCONC dudit système physique. Il est caractérisé en ce que ladite phase de report dans la matière est précédée par une première phase établissant une spécification abstraite du dit système physique et par une deuxième phase évaluant la spécification abstraite établie, ladite première phase consistant à

- associer aux éléments définis par le descriptif concret des données sous forme d'objets,

- associer aux connexions physiques de ces éléments avec d'autres éléments définis par le descriptif concret, des valeurs d'attribut structurel de ces objets,

- regrouper les objets ainsi obtenus en objets représentant chacun un composant physique constitué d'éléments définis par le descriptif concret, auxquels sont associés les objets regroupés dans ce dernier objet,

- associer une valeur d'attribut structurel de ce dernier objet à chaque connexion physique de chacun de ses éléments avec un élément extérieur au composant physique représenté par ce dernier objet,

- doter de plus ce dernier objet d'un attribut fonctionnel dont la valeur est une chaîne de caractères traduisant en langage formel, le comportement fonctionnel du composant physique associé à ce dernier objet,

- réitérer, de façon automatique la procédure précédemment décrite de la première phase, en prenant pour objets, les objets précédemment obtenus, et ceci jusqu'à ne plus pouvoir regrouper d'objets,

- enfin concaténer les valeurs d'attributs fonctionnels des objets résultants, produisant ainsi la spécification abstraite.

Ainsi la phase d'abstraction est constituée de mécanismes transformant le produit d'une étape de la chaîne directe de réalisation, en spécification abstraite transcrite dans un langage formel afin de permettre sa comparaison à la spécification abstraite initiale ou de créer une nouvelle spécification abstraite initiale. Ces mécanismes sont mis en oeuvre au moyen de fichiers informatiques et d'un programme d'ordinateur. Un tel procédé présente plusieurs avantages.

Selon un premier avantage de l'invention, le procédé de réalisation d'un système physique est caractérisé en ce que,

- possédant une spécification abstraite initiale, le descriptif concret est obtenu au moyen d'un outil de conception assisté par ordinateur, et en ce que,

- la deuxième phase évalue la spécification abstraite au moyen d'un outil d'évaluation qui détecte si les spécifications abstraites sont identiques, pour autoriser la phase de report dans la matière de l'ensemble structuré d'éléments défini par le descriptif concret s'il détecte que les spécifications abstraites sont identiques.

Ainsi, le résultat de la phase d'abstraction, sous forme de spécification abstraite, est confronté à la spécification abstraite initiale dans une phase de comparaison détectant les différences entre les deux spécifications, toute différence étant interprétée comme une erreur de réalisation. Une phase de modification de la chaîne directe, propre à annuler l'erreur de réalisation, permet ensuite par réitérations successives du procédé, d'obtenir un système physique conforme à la spécification abstraite initiale.

Généralement la spécification abstraite initiale résulte d'études préalables effectuées par l'être humain à partir d'un cahier des charges établissant ce qu'on attend du système physique à réaliser.

Cependant, il se peut qu'on possède déjà le descriptif concret d'un système physique existant, que l'on souhaite améliorer. Une reprise complète des études peut s'avérer couteuse.

Selon un autre avantage de l'invention, le procédé de réalisation d'un système physique est caractérisé en ce que, possédant un descriptif concret,

- la deuxième phase évalue la spécification abstraite au moyen d'un outil d'évaluation qui permet de modifier la spécification abstraite pour en faire une spécification abstraite initiale,

- un nouveau descriptif concret est obtenu au moyen d'un outil de conception assisté par ordinateur pour obtenir un nouveau système physique par report dans la matière de l'ensemble structuré d'éléments défini par le nouveau descriptif concret.

Les caractéristiques et les détails de réalisation de l'invention seront mieux comprises dans la suite de la description en relation avec les figures dans lesquelles:

- la figure 1 présente un procédé de réalisation de système physique utilisant l'invention,

- la figure 2 présente la combinaison des outils mettant en oeuvre l'invention,

- la figure 3 présente les éléments essentiels d'un outil d'abstraction conforme à l'invention,

- la figure 4 présente l'organigramme d'un algorithme d'inférence suivant l'invention,

- la figure 5 présente l'organigramme d'un algorithme de filtrage suivant l'invention,

- la figure 6 présente un exemple simple de système physique auquel s'applique l'invention,

- les figures 7 à 11 présentent des exemples de composants pouvant faire l'objet de procédures programmées

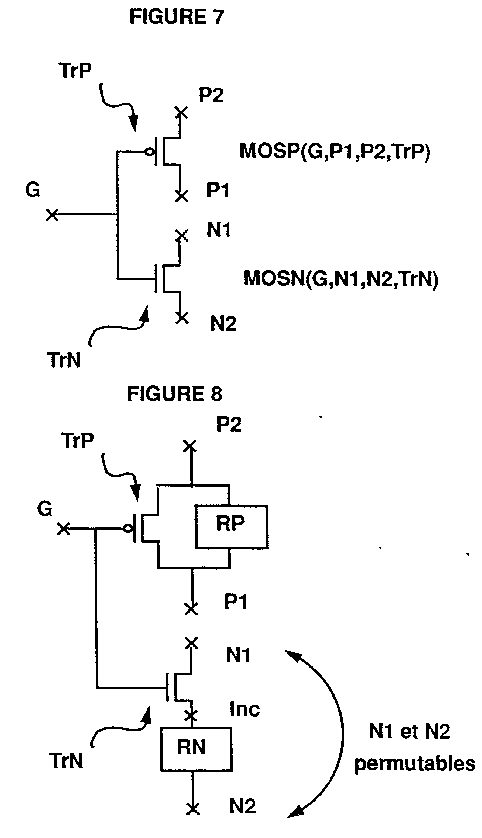

- les annexes 1 à 7 présentent un exemple de procédures programmées adaptées à la reconnaissance des composants des figures 7 à 11.

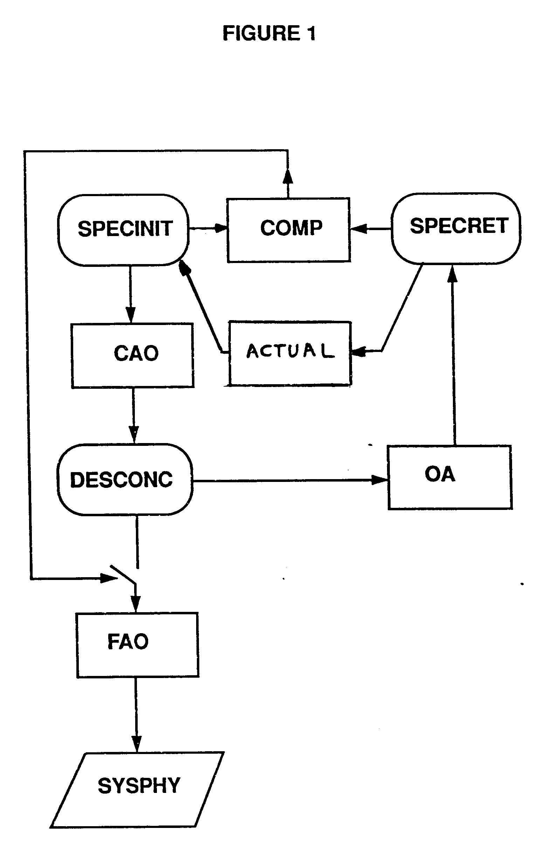

La figure 1 présente un procédé de réalisation d'un système physique conforme à l'invention. Pour réaliser un système physique complexe SYSPHY tel que par exemple un circuit électrique intégré, il est nécessaire d'établir une spécification initiale abstraite SPECINIT de ce système. Cette spécification est écrite dans un langage formel permettant son traitement par un dispositif CAO. Le dispositif CAO est un outil de conception assisté par ordinateur connu de l'état de la technique qui permet d'établir, à partir de la spécification SPECINIT un descriptif concret DESCONC du système SYSPHY. Tout dispositif CAO adapté convient. Une machine de fabrication assistée par ordinateur FAO retranscrit dans la matière le descriptif concret DESCONC pour obtenir de façon systématique le système physique SYSPHY dont le comportement résulte des propriétés naturelles de la matière dont il est alors constitué. Toute machine de fabrication FAO adaptée convient. Un outil d'abstraction OA produit à partir du descriptif concret DESCONC une spécification abstraite SPECRET, dans un langage formel comparable à celui de la spécification initiale abstraite SPECINIT. Un outil d'évaluation COMP établit un signal de validation VAL qui autorise le transfert du descriptif DESCONC à la machine FAO si les deux spécifications SPECINIT et SPECRET sont fonctionnellement identiques. L'outil d'évaluation COMP est, à titre non limitatif un outil de test connu comparant les résultats des deux spécifications SPECINIT et SPECRET, ou un outil connu de preuve formelle établissant que les formes canoniques des deux spécifications sont identiques.

La spécification abstraite SPECINIT est généralement élaborée pendant une phase d'étude, à partir de l'analyse fonctionnelle d'un cahier des charges. Cependant, une entreprise peut posséder un descriptif fonctionnel DESCONC d'un système physique répondant à certains besoins mais pour lequel elle ne possède pas de spécification abstraite SPECINIT permettant son traitement par les outils de conception assistés par ordinateur dont elle dispose, en vue de créer de nouveaux systèmes physiques SYSPHY. L'entreprise peut souhaiter par exemple refabriquer le système physique SYSPHY dans une nouvelle technologie ou simplement de modifier le système physique SYSPHY. Une variante intéressante du procédé de réalisation consiste alors à utiliser l'outil d'abstraction OA pour produire une spécification abstraite SPECRET à partir du descriptif concret DESCONC. On utilise ensuite un outil d'évaluation ACTUAL pour produire une spécification abstraite SPECINIT à partir de la spécification abstraite SPECRET. L'outil dévaluation ACTUAL est par exemple un outil de traitement de texte mis en oeuvre dans un ordinateur et qui permet de modifier la spécification abstraite SPECRET pour l'adapter à une nouvelle technologie où à un nouveau cahier des charges. La spécification abstraite SPECINIT ainsi obtenue est alors utilisable à titre de spécification abstraite initiale de façon à produire un nouveau système physique SYSPHY suivant le procédé de réalisation décrit dans le paragraphe précédent.

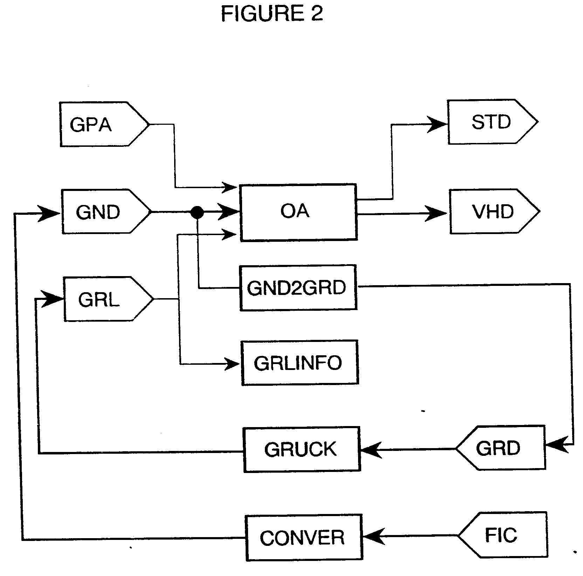

La figure 2 présente cinq outils. Un outil d'abstraction OA, un outil GRUCK pour construire une librairie de règles GRL, un consignateur d'états de la librairie GRLINFO, un constructeur de squelettes de règles GND2GRD, un ou plusieurs convertisseurs de format de données CONVER.

L'outil d'abstraction OA a pour fonction de faire l'abstraction du système physique SYSPHY, de façon à produire une spécification abstraite SPECRET. Comme nous le verrons par la suite, il transforme pour cela un fichier de données GND à partir d'un fichier de règles GRL en un fichier de langage VHD. Le fichier de données GND contient la description du système physique SYSPHY. Le fichier de règles GRL contient les règles assemblées par l'outil GRUCK, à partir de leur forme textuelle GRD, et le fichier de langage de description formel VHD contient les descriptions abstraites produites par l'outil OA. En fin de traitement du fichier GND par l'outil OA, le fichier VHD contient la spécification abstraite SPECRET. L'outil OA dispose d'autre part d'un fichier de données GPA qui contient les librairies du langage de description formelle et un fichier STD dans lequel l'outil OA génère des messages de défaut causés par des erreurs relatives aux données du fichier GND ou relatives aux règles du fichier GRL.

L'outil de construction GRUCK reçoit en entrée un ou plusieurs fichiers GRD dans lesquels sont écrites des règles, définies par l'utilisateur de l'outil OA. Après vérification de la syntaxe d'écriture de ces règles, l'outil de construction GRUCK assemble les règles correctement écrites en une seule librairie contenue dans le fichier GRL. Cette librairie est alors liée à une technologie donnée.

Le consignateur d'états GRLINFO affiche des informations sur les librairies construites par l'outil GRUCK telles que leur version, leur auteur et leur date de création.

L'outil de construction GND2GRD transforme le fichier de données GND en un fichier de règles GRD. Si on possède la liste de connectique LCO d'un circuit composant connu et que cette liste de connectique LCO décrive uniquement ce circuit composant, cet outil utilise l'outil d'abstraction OA pour faire l'abstraction de sa structure et parallèlement élaborer un descriptif formel de son comportement fonctionnel. Une liste LCO est assimilable au descriptif concret d'un circuit composant considéré comme système physique. L'outil de construction GND2GRD génère ainsi un modèle qui pourra être encapsulé dans la partie conditionnelle d'une règle faisant intervenir ce composant. Ceci permet à l'utilisateur de l'outil de générer rapidement des règles à partir de circuits connus en évitant de se tromper. Par exemple, s'il sait que le circuit à étudier comprend des additionneurs et qu'il possède par ailleurs la liste de connectique LCO de chaque type d'additionneur, l'utilisateur humain peut exploiter l'outil de construction GND2GRD pour élaborer une nouvelle règle dans la combinaison de laquelle interviennent ces additionneurs ou tout simplement établir la règle permettant de produire un additionneur.

Un convertisseur CONVER reçoit en entrée un fichier FIC, à partir duquel il génère le fichier GND. Le fichier FIC est un fichier qui contient le descriptif concret du système physique tel qu'il résulte de ce dernier. Le fichier FIC nécessite alors éventuellement une remise en forme pour pouvoir être traité par l'outil OA.

Le fichier GND contient le descriptif concret DESCONC sous une forme permettant son traitement par l'outil OA. A l'ensemble des éléments du descriptif concret, l'outil OA associe des données sous forme d'objets OBJ. Chaque objet est identifié par ses ports NC, ses liaisons internes NI, les vecteurs VC de signaux qu'il véhicule, les composants MN, MP..., qui combinés entre eux, réalisent l'objet. Le port NC d'un objet OBJ1 est une partie de la frontière de cet objet, partagée avec un autre objet OBJ2. Par exemple, un circuit électrique est composé de différents objets OBJ qui échangent entre eux des signaux. Si OBJ1 est un émetteur et OBJ2 une ligne de transmission vers d'autres objets du circuit, OBJ1 possède un port NC constitué de sa borne de sortie sur laquelle est raccordée l'extrémité de l'un des brins de la ligne de transmission vers l'objet OBJ2. Les liaisons internes NI sont les parties de l'objet communes à deux ou plusieurs de ses composants MN, MP... Dans l'exemple d'un circuit électrique, les composants MN, MP... peuvent être des transistors MOS N ou MOS P, mais aussi, et à titre non exhaustif, des portes logiques, des compteurs, des amplificateurs opérationnels. Les signaux VC véhiculés par un objet OBJ1 sont des grandeurs physiques présentes sur les ports NC de cet objet. Dans l'exemple précédent, ce peut être, à titre non exhaustif une tension, un courant électrique ou encore une valeur numérique binaire.

Dans le fichier GND, chaque port NC est identifié par un numéro d'ordre et le nom du ou des signaux VC présents sur le port NC; chaque liaison interne NI est identifiée par un numéro d'ordre, par le nom et éventuellement par le type du ou des signaux présents sur la liaison; chaque vecteur de signaux est identifié par le nom du premier signal, son premier indice et son dernier indice; chaque composant MN, MP... est identifié par les attributs de l'objet OBJC réalisant ce composant. Par exemple, si l'objet OBJC est un transistor, il sera identifié par les huit valeurs des variables $g, d, s, x, y, w, l$ et $c$ qui sont respectivement les numéros des ports NC raccordés $g$ à la grille, $d$ au drain, $s$ à la source, les coordonnées $x$ et $y$ de la localisation physique du transistor dans le circuit, $w$ la largeur et $l$ la longueur de la grille, $c$ la valeur de la capacité de la grille.

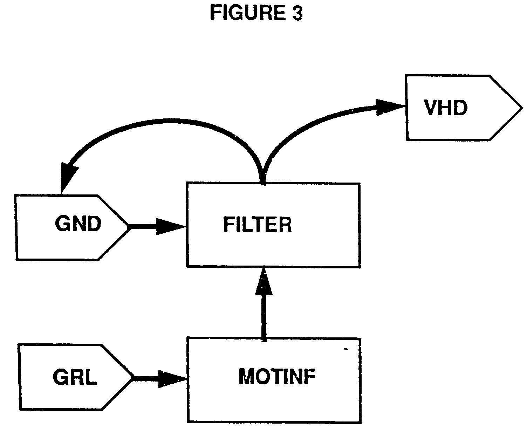

Comme nous le voyons dans la figure 3, l'outil d'abstraction OA contient un moteur d'inférence MOTINF qui active successivement chacune des règles contenues dans le fichier de règles GRL. Pour activer une règle, le moteur d'inférence MOTINF sélectionne une règle dans le fichier GRL puis transfère cette règle vers un filtre FILTER. Les critères de sélections sont de deux types, ascendant et descendant. Suivant le critère ascendant, à partir des objets reconnus par les règles précédemment activées, MOTINF sélectionne la première règle dont tous les objets de la prémisse font partie des objets reconnus. Suivant le critère descendant, l'activation d'une règle détermine les objets à reconnaître pour satisfaire la prémisse de cette règle, on parle alors de mode dirigé par les buts. Chaque objet à reconnaître déclenche l'activation de la règle ou des règles dont le modèle de cet objet figure dans la partie actionnelle de cette règle, on parle alors de mode dirigé par les données. La sélection résulte de l'interprétation d'un opérateur par le moteur d'inférence MOTINF. Cet opérateur est par exemple un pointeur noté "→" qui contient la tête de l'espace mémoire du fichier GRL où est stocké la règle sélectionnée. Plus précisément, le pointeur est différencié -> en mode dirigé par les buts et +> en mode dirigé par les données. Une règle est composée essentiellement de trois éléments: une enveloppe, un bloc conditionnel et un bloc actionnel. L'enveloppe est composée d'un nom qui débute l'énoncé de la règle, et d'un mot clé END qui termine l'énoncé de la règle. Le nom est une chaîne de caractères permettant d'identifier la règle.

Le bloc conditionnel est identifié par un mot clé IF, il contient le modèle d'un composant construit OBJC à reconnaître. Le modèle d'un composant construit OBJC est constitué de la combinaison d'éléments OBJ. Les éléments OBJ sont combinés à l'aide d'opérateurs ET, OU, NON, OBSERVE et REDUIT. L'opérateur ET appliqué à deux éléments OBJ implique que ces deux éléments interviennent simultanément dans la combinaison. L'opérateur OU appliqué à deux éléments OBJ implique que l'un au moins de ces deux éléments intervient dans la combinaison. L'opérateur NON appliqué à un élément OBJ implique que cet élément ne doit pas intervenir dans la combinaison. L'opérateur OBSERVE appliqué à un élément OBJ implique que cet élément ne fait pas partie du composant OBJC. L'opérateur REDUIT, appliqué à une liaison interne NI de l'objet OBJC, vérifie qu'aucun autre élément OBJ, que ceux combinés suivant la règle, ne partage cette liaison interne NI et que cette liaison NI n'est pas un port.

Le bloc actionnel est identifié par un mot clé ALORS, il contient une ou plusieurs actions à déclencher lorsqu'un composant conforme au modèle, est reconnu. Si plusieurs actions sont à déclencher, elles sont séparées par un mot clé ET. Ces différentes actions sont concrétisées par les opérateurs :=, CONSTRUIT, ACTIVE, ACTUALISE et ECHO. L'opérateur := affecte une valeur à un champ d'un composant OBJC. L'opérateur CONSTRUIT construit un composant OBJC reconnu en conformité avec le modèle. La seule restriction d'écriture à ce niveau est qu'il ne doit y avoir au plus qu'une seule action de type CONSTRUIT dans la partie actionnelle d'une règle donnée. L'opérateur ACTIVE permet d'activer certaines fonctions pré programmées. L'opérateur ACTUALISE permet de remplacer l'ancienne valeur d'un attribut par une nouvelle valeur. L'opérateur ECHO permet d'afficher un message constitué d'une chaîne de caractères.

Un objet OBJ, de type OBJC ou OBJE, se distingue par une ou plusieurs propriétés. Chaque propriété est associée à un champ de données par son nom. Dans une terminologie objet, on désigne plus communément ces champs nommés d'un objet sous le terme d'attribut. Un attribut est le champ nommé d'un objet qui contient une ou plusieurs valeurs et qui peut être lu ou écrit. L'accès à la valeur contenue dans un champ se fait à l'aide d'une variable instanciable à cette valeur. La valeur contenue dans un champ est exclusivement déterminée par le bloc actionnel d'une règle. La structure d'un objet OBJ, OBJC ou OBJE est reconnue par un nom suivi d'un mot clé AVEC, suivi à son tour d'une ou plusieurs opérations sur les propriétés de cet objet.

Les blocs conditionnel et actionnel comprennent deux types essentiels d'opérations sur les champs de données d'un objet OBJ. La première opération, située dans le bloc conditionnel, est l'unification d'une valeur contenue dans un champ à une variable, définie par l'opérateur =. La deuxième opération, située dans le bloc actionnel, est l'affectation d'une variable instanciée à un champ, définie par l'opérateur :=.

Les ports NC et les liaisons internes NI sont des objets OBJE. Une propriété distinctive de ces objets OBJE est qu'ils représentent et supportent les propriétés attachées aux liaisons de type signaux qui connectent les autres OBJ, représentatifs des composants tels que par exemple des transistors. Un objet de type signal est défini par le mot clé SIGNAL suivi de la description d'un composant NC ou NI. La description du dit composant s'articule autour d'un mot clé AVEC, lequel mot clé est précédé d'une variable identifiant le composant et suivi par une liste d'opérations sur des champs de données UTILISATION, MODE, MARQUE, TYPE, RESOLUTION, ATTRIBUT, VISIBILITE, appartenant à l'objet OBJC. La définition d'un signal est soit référencée dans le modèle de l'objet NC ou NI, soit actualisé dans le bloc actionnel d'une règle, elle n'est jamais construite explicitement. Le champ de données UTILISATION est lu ou actualisé par une valeur telle que "horloge", "verrou", "bascule", "commutation", "précharge" ou "trois états", une telle valeur sert à identifier la nature du signal mais elle peut aussi renseigner sur sa fonction par exemple dans le cas d'une valeur "trois états", la valeur est alors positionnée par le bloc actionnel d'une règle. Le champ de données MODE permet de lire une valeur telle que "émission", "réception", "duplexé", une telle valeur sert à identifier le sens de circulation du signal, elle n'est jamais actualisée par le bloc actionnel d'une règle. Le champ de données MARQUE contient un caractère alphabétique qui décrit l'état du signal, sa valeur est lue ou actualisée par le bloc actionnel d'une règle. Le champ TYPE contient une valeur telle que "binaire", "numérique", "analogique", cette valeur définit le type du signal, elle est lue ou actualisée par le bloc actionnel d'une règle. Le champ RESOLUTION contient une valeur telle que "bus", "registre", cette valeur définit l'espèce fonctionnelle du signal, elle est lue et actualisée par le bloc actionnel d'une règle. Le champ ATTRIBUT contient une ou plusieurs valeurs fonctionnelles du signal qui en permettent une interprétation formelle par un langage de spécification fonctionnelle. Le champ VISIBILITE contient l'une des deux valeurs "interne" ou "externe", ces deux valeur permettent de définir si le signal présent sur l'objet OBJC est à considérer comme le signal, respectivement d'un composant NI ou NC de l'objet OBJ.

Un objet composant OBJC est formé d'un ou plusieurs objets élémentaires OBJ. La structure d'un objet OBJE est définie comme celle d'un objet OBJC par le mot clé AVEC précédé du nom du modèle auquel l'objet OBJE se réfère et auquel succède une suite d'opérations sur les champs de données de cet objet OBJE. Pour un tel objet, ces opérations se réduisent essentiellement à l'actualisation de ces champs par les valeurs d'identifications d'objets NC ou NI auxquels il est raccordé. Par exemple, il est connu qu'un transistor MOS est caractérisé par une grille, un drain, une source, la largeur et la longueur de sa grille, et s'il est intégré dans un circuit, les coordonnées de sa position dans ce circuit.

Si l'objet OBJE est un transistor MOS N, son nom est alors "mos_n" et ses propriétés sont définies à l'aide de sept champs g,d,s,x,y,w et l où g contient le nom G du signal de grille, d contient le nom D1 du signal de drain, s contient le nom S1 du signal de source, x contient l'abscisse N1 et y l'ordonnée N2 du transistor, w contient la largeur W1 et l la longueur L1 de la grille. Cet objet OBJE est alors décrit de la façon suivante:

$$\text{mos\_n AVEC g=G; d=D1; s=S1; x=N1; y=N2; w=W1; l=L1.}$$

Un circuit complet est lui-même un objet OBJC, défini par le mot clé AVEC précédé d'un nom et suivi d'opérations sur ses champs de données ENTREE, COMMANDE, INTERNE, SORTIE, TEXTE, RETARD, AUTRES. Le champ ENTREE contient les signaux d'entrée du circuit, le champ COMMANDE contient la liste des signaux de commande du circuit, le champ INTERNE contient la liste des signaux internes du circuit, le champ SORTIE contient la liste des signaux de sortie du circuit, le champ TEXTE contient une description formelle du comportement du circuit, le champ RETARD contient des valeurs temporelles du circuit, le champ AUTRES contient les autres attributs de l'objet OBJ qu'il peut encore être souhaitable d'identifier.

La description du comportement du circuit contenue dans le champ TEXTE est constituée de chaînes figées de caractères minuscules, entre lesquelles sont insérées des chaînes de caractères majuscules qui représentent des variables. Ces variables sont instanciées aux nom des signaux lors de l'édition qui suit le processus d'abstraction. L'ensemble des descriptions est concaténé dans le fichier VHD. La syntaxe de la description est, à titre d'exemple non limitatif, celle du langage connu Vhdl. Dans ce langage, le traitement des signaux y est décrit de façon explicite. Les signaux sont interprétés sous forme de flux de données entrant et sortant d'unités élémentaires, ayant chacune un comportement spécifique, dont résulte le comportement global du système. La description complète d'une unité en langage Vhdl est exploitable essentiellement par des outils connus de simulation, de preuve formelle ou d'abstraction. Les interfaces de chaque unité avec les autres unités du circuit sont constituées de ports d'entrées-sorties auxquels sont associés des déclarations d'attributs des signaux y transitant. Chaque signal est défini par un nom, un mode et un type qui apparaissent dans la partie déclarative de l'exposé de l'unité. Le nom est l'identificateur du signal, tel que l'a défini le concepteur du circuit. Le mode indique la direction du flux de données associé au signal à travers le port considéré: entrée, sortie ou duplex. Le type indique la nature du signal telle que binaire, numérique, analogique en tension ou en courant, etc. L'architecture de chaque unité définit le modèle d'un flux de données interne à l'unité. Chaque signal y est défini par un nom et un type.

Le filtre FILTER fonctionne de la façon suivante. A chaque fois qu'il reçoit une nouvelle règle du moteur d'inférence MOTINF, le filtre FILTER confronte l'ensemble des données, représentatives d'objets OBJE, contenues dans le fichier GND, au modèle d'un objet OBJC, encapsulé dans le bloc conditionnel de la règle. Le filtre FILTER sélectionne les objets OBJE satisfaisant complètement la partie conditionnelle de la règle. Pour cela, le filtre FILTER fait référence au nom de la classe à laquelle chaque objet OBJE appartient et à un ou plusieurs attributs de cet objet OBJE. Les noms des attributs sont définis au niveau de la classe. La référence au nom d'un attribut permet d'accéder à la valeur décrivant l'objet OBJE pour cet attribut. Chaque valeur permet d'instancier une ou plusieurs variables libres du modèle.

A chaque fois qu'est sélectionné un ensemble complet d'objets OBJE satisfaisant la partie conditionnelle de la règle, est déclenchée la partie actionnelle de cette règle. La partie actionnelle de la règle comprend deux actions essentielles. La première action est une action de classification qui consiste à produire un nouvel objet OBJC, instance de la classe du modèle, et dont les attributs structurels résultent d'une combinaison des attributs structurels des objets OBJE sélectionnés. La deuxième action consiste à remplacer, dans la représentation interne des données qui est construite initialement par la procédure programmée à partir du fichier GND, l'ensemble des objets OBJE alors sélectionnés par ce seul objet OBJC. En phase finale, l'ensemble des descriptions comportementales des objets OBJE, présents dans la représentation interne des données, est édité.

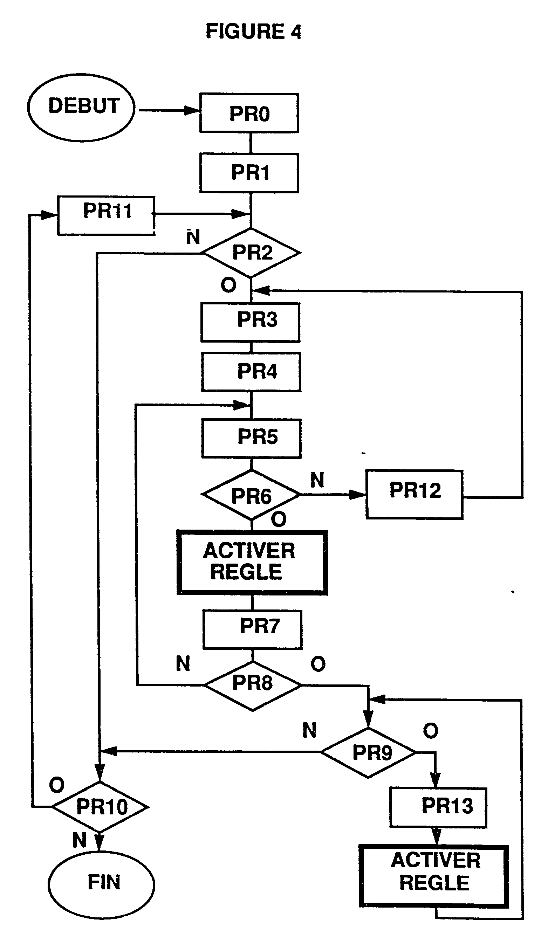

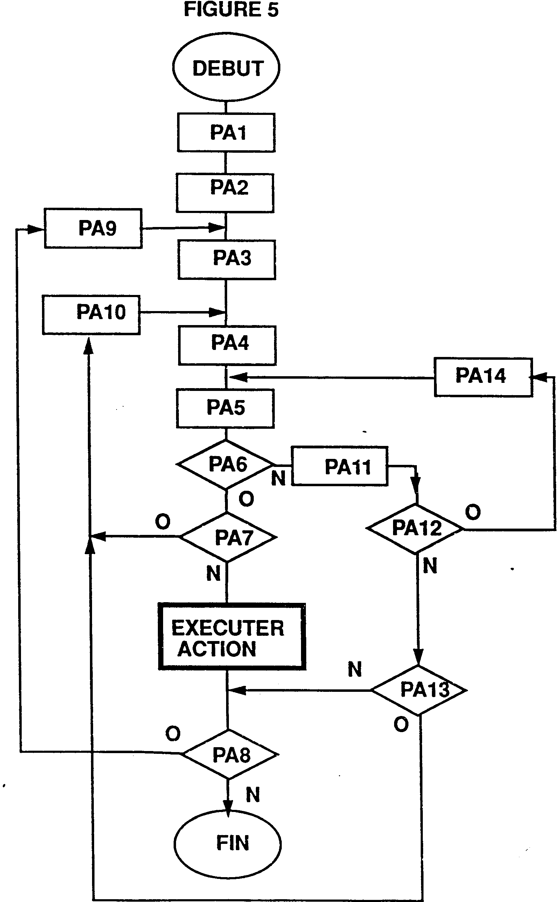

La figure 4 présente la procédure de sélection des règles dont le point d'entrée est désigné par DEBUT et le point de sortie par FIN. Cette procédure a pour but de sélectionner successivement chacune des règles de la librairie GRL et de faire appel, pour chacune des règles sélectionnée R, à une autre procédure ACTIVER_REGLE décrite en référence à la figure 5.

Comme le montre la figure 5, la procédure ACTIVER_REGLE possède un point d'entrée désigné par DEBUT et un point de sortie désigné par FIN. Cette procédure met en oeuvre les mécanismes de filtrage qui regroupent les objets OBJE de la liste de connectique en objets OBJC, et déclenche la phase EXECUTER_ACTION, dans laquelle la partie action de la règle sélectionnée R, associe une valeur d'attribut structurel de l'objet OBJC. Cette valeur d'attribut structurel représente la connexion physique de cet objet avec ceux qui lui sont extérieurs. Elle dote de plus l'objet OBJC d'un attribut fonctionnel dont la valeur est une chaîne de caractères traduisant en langage formel, le comportement fonctionnel du composant physique associé à l'objet OBJC.

La partie conditionnelle d'une règle R contient un modèle M de l'objet OBJC. Ce modèle M est constitué d'une combinaison logique d'expressions E. En parcourant l'ensemble des données de la liste de connectique (netlist), les seules retenues sont celles satisfaisant la combinaison logique d'expressions E1.

La première phase PA1 a pour but de limiter l'application du modèle aux seuls espaces restreints de données susceptibles de le satisfaire et ainsi d'optimiser le processus de filtrage mis en oeuvre. Une donnée est constituée de l'association de une ou plusieurs valeurs. Les données sont contenues dans des listes. Les listes de données LD sont organisées de façon a toujours pouvoir accéder à la donnée DS suivant une donnée connue D de la liste LD. Chaque donnée est affectée d'un champ MAR1 dont la valeur est nulle tant que cette donnée n'a pas été utilisée. Cette limitation évite d'effectuer des recherches inutiles d'objets OBJC là où ils n'ont aucune raison d'apparaître. Pour cela, la phase PA1 construit une liste LVPA de valeurs de points d'ancrage VPA. Une valeur de point d'ancrage est une valeur que doit nécessairement posséder un attribut caractéristique de l'objet OBJC. Les sous-ensembles de valeurs de la liste LVPA serviront a fournir des valeurs initiales au modèle M, ce qui restreindra l'espace de recherche des données satisfaisant le modèle.

Dans la phase PA2, une fonction INITIAL positionne les variables du modèle à un état de variables libres. La fonction INITIAL initialise une pile MEMOV au contenu des variables ainsi positionnées. La pile MEMOV est destinée à conserver les états successifs des variables du modèle dans le déroulement de la procédure. La première valeur VPA de la liste LVPA est ensuite propagée dans le modèle M. C'est à dire que les variables du modèle, correspondant aux points d'ancrage de valeur VPA, sont instanciées à ces valeurs.

Dans la phase PA3, la première expression E du modèle M est sélectionnée. A chaque expression E du modèle est associé un pointeur PSDC sur la donnée courante D qui sera présentée à E. Ce pointeur contient l'adresse de la donnée courante devant être confrontée au modèle.

La phase PA4 dispose de l'expression courante E provenant de PA3 ou de PA10. A partir de l'expression E est sélectionné une première donnée D1 dont le type correspond a celui de E et dont le champ MAR1 possède une valeur nulle. La donnée D1 devient ainsi la donnée courante D.

Dans la phase PA5, la valeur du champ MAR1 de la donnée courante D fournie par PA4 ou PA14 est mise à 1. L'adresse AO de la donnée D est enregistrée dans le pointeur PSDC associé à l'expression E. La fonction MEMORISER est exécutée. La fonction MEMORISER conserve l'état des variables du modèle au moment de l'activation de la phase PA5. Cet état est conservé au sommet de la pile MEMOV.

Dans la phase PA6, la donnée courante D, pointée par PSDC, est confrontée à l'expression courante E par mise en oeuvre du filtre FILTER. Le mécanisme de confrontation du filtre FILTER consiste à instancier les variables de l'expression E à l'aide des valeurs de la donnée courante D sans qu'il y ait contradiction avec les valeurs des variables précédemment instanciées dans l'expression E. La donnée courante D satisfait alors l'expression E, ce qui déclenche la phase PA7. Si la donnée D ne satisfait pas l'expression E, la phase PA11 est déclenchée.

Dans la phase PA7, un test est effectué sur l'existence d'une conjonction logique de l'expression satisfaite E avec une expression suivante ES de la règle R.

L'existence d'une expression ES nécessite de vérifier sa satisfiabilité, ce qui déclenche la phase PA10. S'il n'existe pas d'expression ES, la phase EXECUTER_ACTION est déclenchée.

Dans la phase EXECUTER_ACTION, les valeurs contenues dans les variables du modèle sont propagées dans la partie action de la règle R. Les instructions de la partie action sont exécutées. La fin d'exécution de la partie active de la règle déclenche la phase PA8.

Dans la phase PA8, il est testé si d'autres données VPA de la liste LVPA, à la suite des données déjà testées sont disponibles. L'existence de telles données déclenche la phase PA9. La fin de la liste LVPA termine la procédure signalée par FIN.

Dans la phase PA9, la fonction INITIAL positionne les variables du modèle à un état de variables libres. La fonction INITIAL initialise la pile MEMOV au contenu des variables ainsi positionnées. La pile MEMOV est destinée à conserver les états successifs des variables du modèle dans le déroulement de la procédure. La première valeur VPA de la liste LVPA est ensuite propagée dans le modèle M. C'est à dire que les variables du modèle, correspondant aux points d'ancrage de valeur VPA, sont instanciées à ces valeurs. La procédure est réitérée comme précédemment à partir de la phase PA3.

Dans la phase PA10, l'expression suivante ES, déterminée par la phase PA7 ou PA13, est considérée comme nouvelle expression courante E dans la phase PA4, déclenchée à la suite de la phase PA10.

La phase PA11 est déclenchée par l'étape PA6 dans le cas où la donnée courante D ne satisfait pas l'expression E. La valeur nulle est alors affectée à la marque MAR1 de la donnée D pour indiquer que cette donnée est à nouveau disponible. La fonction REMETTRE est activée. Cette fonction remet les variables dans le dernier état mémorisé au sommet de la pile MEMOV, c'est à dire avant leur instanciation par les valeurs de la donnée D. A cette phase succède la phase PA12.

Dans la phase PA12, la liste LVPA est scrutée pour détecter la présence, dans cette liste de données disponibles VPA pouvant satisfaire l'expression E.

L'existence de telles données déclenche la phase PA14. Le cas contraire déclenche la phase PA13.

Dans la phase PA13, un test est effectué sur l'existence d'une disjonction logique de l'expression non satisfaite E avec une expression suivante ES de la règle R. L'existence d'une expression ES nécessite de vérifier sa satisfiabilité, ce qui déclenche la phase PA10. S'il n'existe pas d'expression ES, la phase PA8 est déclenchée.

Dans la phase PA14, la donnée VPA, détectée dans la phase PA12, devient la nouvelle donnée courante D. C'est à dire que son adresse est rangée dans le pointeur PSDC. La valeur 1 est affectée à la marque MAR1 de cette donnée. La procédure précédente est ensuite réitérée à partir de la phase PA5.

La FIN de cette procédure provoque le retour à la procédure appelante décrite en référence à la figure 4.

Dans la phase PRO, sont construites deux listes de règles LR- et LR+. Chaque règle R de la liste LR-, respectivement de la liste LR+, est affectée d'un champ MAR-, respectivement MAR+, à valeurs initialement nulles.

Dans la phase PR1, un pointeur PSEQUENCE est branché sur la première règle R de la liste LR-.

Dans la phase PR2 est testée la valeur du champ MAR- de la règle R pointée par PSEQUENCE. Une valeur nulle déclenche la phase PR3. Une valeur non nulle déclenche la phase PR10.

Dans la phase PR3, la valeur du champ MAR- est mise à 1 pour indiquer le choix de la règle R et éviter de l'activer inutilement une seconde fois.

Dans la phase PR4, la règle R est rangée au sommet d'une pile PILR. Le rôle de cette pile est de mettre en attente les règles qui sont sélectionnées par MOTINF, mais qui n'ont pas tous les éléments nécessaires pour être activées et sont donc non activables. En effet, le modèle d'une règle fait référence a des objets composes OBJC, eux mêmes composes d'autres OBJC ou d'objet OBJE. Donc, une règle désignée par exemple par R1 pourra faire référence dans sa partie modèle a un OBJC qui pourra lui même être construit par une autre règle R2 non encore activée à cet instant. Il faudra donc mettre en attente dans la pile PILR la règle R1, puis chercher à activer la règle R2, et enfin revenir à la règle R1 en explorant la pile selon un mode dit "dernier entré premier sorti". Grâce à la pile PILR, ce processus sera itéré sur un nombre quelconque de règles. C'est ce qui est réalisé par les phases PR4, PR5, PR7, PR8 que nous décrivons à présent.

Dans la phase PR5, la règle R du sommet de la pile PILR est chargée dans le registre de travail.

Dans la phase PR6 est effectué un test pour déterminer si la règle R est ou non activable. Une réponse positive déclenche la phase ACTIVER_REGLE, une réponse négative déclenche la phase PR12. La règle R est activable si chaque classe d'objet OBJC figurant dans le modèle M de la règle R est identifiable à une classe d'objet OBJC contenue dans une liste RECHERCHE. La liste RECHERCHE contient toutes les classes d'objets OBJC construits par l'activation précédente d'une règle. Le test de la phase PR6 s'effectue de la façon suivante. Chaque classe d'objet OBJE du modèle M est comparée au contenu de la liste RECHERCHE. Dès qu'une classe d'objet OBJE n'est pas répertoriée dans la liste RECHERCHE, cette classe constitue une classe d'objets à construire OX, ce qui déclenche la phase PR12. Si aucune classe d'objet OX n'est détectée, la règle R est activable. Au retour de la procédure déclenchée par la phase ACTIVER_REGLE, décrite précédemment, s'enclenche la phase PR7.

Dans la phase PR7, la règle R qui vient d'être activée est retirée de la pile PILR. Le nom de la classe de l'objet OBJC qui vient d'être construit par la partie active de la règle, est ajouté au contenu de la liste RECHERCHE. Les objets OBJC de la liste RECHERCHE seront ainsi utilisables par d'autres règles.

La phase PR8 est un test sur le contenu de la pile PILR. Si la pile PILR est non vide, la procédure est réitérée à partir de la phase PR5. Si la pile PILR est vide, la phase PR9 est déclenchée.

La phase PR9 est un test sur le contenu de la liste LR+. La détection d'une règle R de la liste LR+ dont la valeur contenue dans le champ MAR+ est nul, déclenche la phase PR13. L'absence de champ MAR+ contenant une valeur nulle déclenche la phase PR10. La phase PR9 consiste à tester s'il existe une règle de LR+ non marquée à 1 dans MAR+ et telle que tous les OBJC référencés dans son modèle M soient obligatoirement cités dans la liste RECHERCHE.

La phase PR13 consiste à accéder à un telle règle et à marquer son champ MAR+ à 1. On active ensuite la règle par ACTIVER REGLE et on itère en PR9.

La phase PR10 est un test sur le contenu de la liste LR-. L'existence d'une règle R suivante dans la liste LR-, avec une valeur nulle dans le champ MAR-, déclenche la phase PR11. L'absence de telle règle R termine alors la procédure en FIN.

Dans la phase PR11, l'adresse de la règle R détectée dans la phase PR10, est rangée dans le pointeur PSEQUENCE qui détermine ainsi un nouveau choix de règle R pour la continuation de la procédure à partir de la phase PR2.

Dans la phase PR12 est recherchée la règle RX à activer pour construire les objets de type OX détecté dans la phase PR6. Une fois trouvée, la règle RX est considérée comme une règle choisie R et la procédure est réitérée à partir de la phase PR3.

Le cycle PR3, PR4, PR5, PR6, PR12 qui vient d'être décrit est réitéré autant de fois que nécessaire pour aboutir à une règle de LR- qui soit activable en PR6.

Les procédures que nous venons de décrire sont bien adaptées à la reconnaissance de circuits pré définis par application de règles dont le bloc conditionnel encapsule un modèle du circuit recherché. D'autres procédures sont possibles sans sortir du cadre de la présente invention. Les annexes 1 à 7 donnent, à titre non limitatif un exemple de mise en oeuvre d'une fonction pré définie de reconnaissance de circuits duaux.

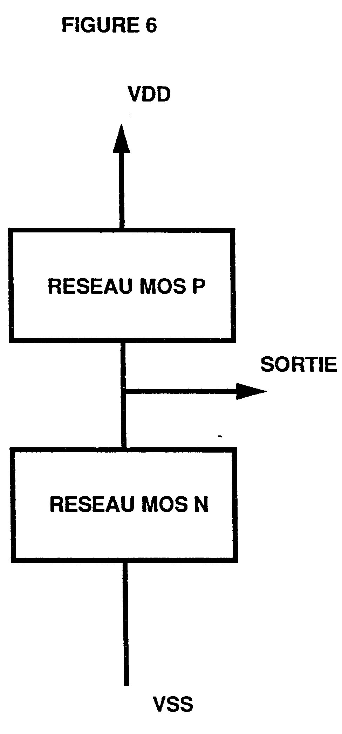

La figure 6 montre un circuit CMOS dual, formé de deux réseaux de transistors CMOS N raccordés à un potentiel VSS et CMOS P raccordés à un potentiel VDD, fonctionnellement complémentaires et raccordés à une même sortie S. Le comportement électrique de réseaux duaux est tel que pour toute configuration des signaux de commande, un et un seul des deux réseaux est passant.

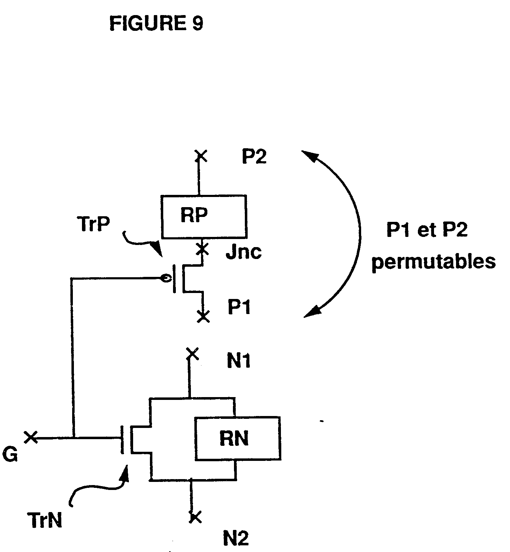

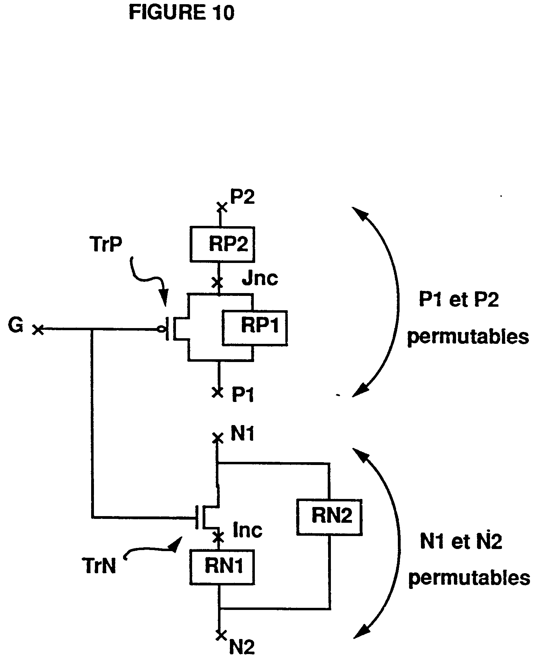

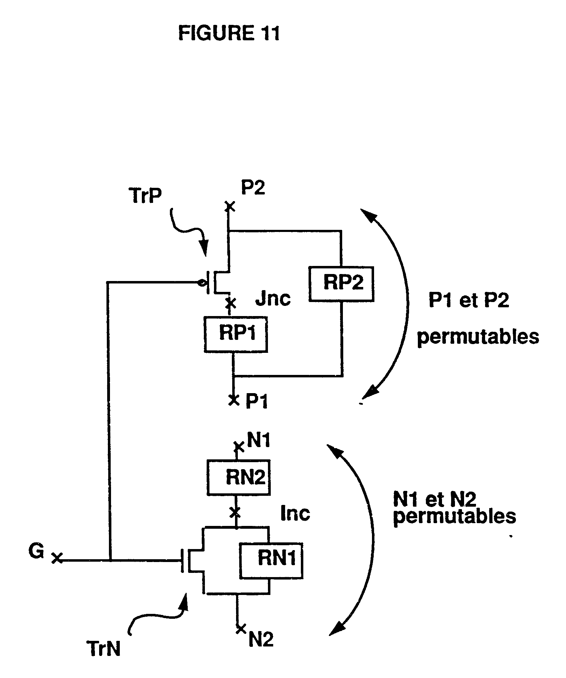

La figure 7 montre un exemple simple de circuits duaux constitués respectivement d'un transistor MOSP et d'un transistor MOSN commandés par le même signal de grille en G. La source et le drain du transistor MOSP sont raccordés à d'autres éléments du circuit en P1 et en P2. La source et le drain du transistor MOSN sont raccordés à d'autres éléments du circuit en N1 et en N2. Un seul de ces deux transistors est passant à la fois. Pour des circuits plus complexes, les réseaux duaux sont configurés structurellement l'un et l'autre de façon à ce que deux éléments disposés en série dans un des réseaux corresponde à une disposition symétrique parallèle dans l'autre réseau. La figure 8 illustre cette propriété en présentant un ensemble de deux transistors, TrP de type MOSP et TrN de type MOSN qui partagent, comme dans la figure 7, une même connexion de grille G, les transistors TrP et TrN sont de plus raccordés, respectivement en parallèle sur un réseau RP et en série sur un réseau RN. Cet ensemble constitue une paire de réseaux duaux si et seulement si les réseaux RP et RN constituent eux même une paire de réseaux duaux. D'autres configurations possibles de réseaux duaux sont présentées dans les figures 9 à 11. Dans la figure 9, le réseau RP étant en série avec le transistor TrP, le réseau RN est en parallèle avec le transistor TrN. La figure 10 présente une combinaison par adjonction du cas de la figure 9 à celui de la figure 8 avec respectivement RP égal à RP2 et RP égal à RP1. La figure 11 présente une combinaison par adjonction du cas de la figure 8 à celui de la figure 9 avec respectivement RP égal à RP2 et RP égal à RP1.

Les circuits des figures 7 à 11 présentent un intérêt particulier lorsque P2 est raccordé à un potentiel Vdd exprimant le "1" logique, N2 est raccordé à un potentiel Vss exprimant le "0" logique, P1 et N1 sont raccordés à une sortie commune.

Dans le premier cas, figure 7, un signal Sortie est donné par l'équation Q:

Sortie = non G.

Dans le second cas, figure 8, si Q(RP) est l'équation résultante du réseau RP:

Sortie = non G ou Q(RP).

Dans le troisième cas, figure 9, avec la même convention:

Sortie = non G et Q(RP)

Dans le quatrième cas, figure 10, si Q(RP1) et Q(RP2) sont les équations résultantes respectivement des circuits RP1 et RP2:

Sortie = (non G ou Q(RP1)) et Q(RP2)

Dans le cinquième cas, figure 11, avec la même convention:

Sortie = (non G et Q(RP1)) ou Q(RP2)

La reconnaissance automatique de circuits entrant dans l'un des cas de figures 7 à 11 et la génération automatique de la description formelle de leurs fonctionnalités est réalisée, au moyen d'un ordinateur, par les procédures récursives des annexes 1 à 7.

En annexe 1, la procédure de recherche des sorties résultant de réseaux duaux est essentiellement constituée de deux phases Ph100 et Ph101. La phase Ph100 scrute l'ensemble des signaux de sortie NP du circuit étudié. Pour chaque signal de sortie NP, la phase Ph101 est réitérée. Dans la phase Ph101, la question se pose de savoir si le signal NP résulte de la sortie d'un circuit CMOS DUAL(G,P1,P2,N1,N2,Q) avec G pour variable représentant un signal de grille commun à deux transistors TrP et TrN, P1 instancié à la valeur sortie, P2 instancié à la valeur vss, N1 instancié à la valeur sortie, N2 instancié à la valeur vdd et Q est l'équation fonctionnelle associée à un tel réseau dual. La phase 101 appelle donc la procédure CMOS DUAL définie à l'annexe 2.

En annexe 2, la procédure CMOS DUAL est essentiellement constituée de la succession des phases Ph201 de reconnaissance d'un circuit du type de la figure 7, Ph202 de reconnaissance d'un circuit du type de la figure 8, Ph203 de reconnaissance d'un circuit du type de la figure 9, Ph204 de reconnaissance d'un circuit du type de la figure 10, Ph205 de reconnaissance d'un circuit du type de la figure 11 et Ph 206 qui conclue à un échec de reconnaissance d'un circuit dual pour les valeurs instanciant les variables d'appel de la fonction. Dans les phases Ph201, Ph202, Ph203, Ph204 et Ph205, la reconnaissance du circuit se fait par l'appel respectif des fonctions DUAL1, DUAL2, DUAL3, DUAL4 et DUAL5 avec leurs variables unifiées à celles de la procédure appelante. Jusqu'à la réussite qui retourne la valeur vrai, les appels de fonctions DUAL2 à DUAL5 se font avec toutes les permutations des noeuds N1, N2 ou P1, P2 rendues possibles par la symétrie de comportement du drain et de la source d'un transistor CMOS. Ainsi, rien ne change si sur la figure 8, le réseau RN est situé physiquement en amont du transistor TrN ou si sur la figure 9, le réseau RP est situé physiquement en aval du transistor TrP. Cette remarque reste valable pour les réseaux RN1 et RP2 de la figure 10 ou les réseaux RN2 et RP1 de la figure 11.

En annexe 3, la procédure DUAL1 est appelée avec, en principe la variable G libre car le but de cette procédure est d'identifier un couple de transistors TrP et TrN dont la grille est raccordée à un noeud commun G, conformément à la structure présentée en figure 7. Les variables P1, P2, N1, N2 encore libres seront instanciées en cas de réussite en Ph302. En Ph301, l'ensemble des couples de transistors MOS TrN et TrP disponibles dans le circuit électrique et dont les grilles sont raccordées à un même noeud G, sont scrutés. Un couple de transistors (TrN,TrP) est disponible lorsqu'il n'a pas été marqué par un choix précédent dans une autre procédure. Pour chacun de ces couples de transistors, il est testé en Ph302 si le transistor TrN a sa source et son drain raccordés en N1 et N2, et si le transistor Trp a sa source et son drain raccordés en P1 et P2. Si les deux conditions sont vérifiées, alors en Ph303, la valeur vrai est retournée vers la procédure appelante, la variable Equation est instanciée au signal en G, les variables P1, P2, N1, N2 sont instanciées de fait. Sinon en Ph304, les transistors TrN et TrP sont laissés disponibles pour d'éventuels tests ultérieurs, les variables sont remises dans leur état mémorisé en Ph300 pour faire un retour arrière sur le test effectué en Ph302 ou pour retourner les variables dans leur état initial en cas d'échec en Ph305.

Les procédures DUAL2 à DUAL5 sont basées sur le même principe que la procédure DUAL1.

Comme nous le voyons en annexe 4, la procédure DUAL2 se distingue essentiellement en Ph402 où il est différemment testé si le transistor TrN a son drain et sa source raccordés en N1 et au noeud Inc d'un réseau RN. Ce cas correspond à celui de la figure 8. Dans ce cas, il faut que le réseau RN soit le dual d'un réseau RP raccordé en P1 et P2. Cette condition se traduit par l'appel récursif de la fonction CMOS DUAL, dans lequel la variable N1 est instanciée à la valeur du noeud Inc. En Ph403, la variable Equation est instanciée à la disjonction du signal en G et de l'équation Q retournée par l'appel récursif de CMOS DUAL satisfaisant les conditions de Ph402.

Comme nous le voyons en annexe 5, la procédure DUAL3 se distingue essentiellement en Ph502 où il est différemment testé si le transistor TrP a son drain et sa source raccordés en P1 et au noeud Jnc d'un réseau RP. Ce cas correspond à celui de la figure 9. Dans ce cas, il faut que le réseau RP soit le dual d'un réseau RN raccordé en N1 et N2. Cette condition se traduit par l'appel récursif de la fonction CMOS DUAL, dans lequel la variable P2 est instanciée à la valeur du noeud Jnc. En Ph503, la variable Equation est instanciée à la conjonction du signal en G et de l'équation Q retournée par l'appel récursif de CMOS DUAL satisfaisant les conditions de Ph502.

Comme nous le voyons en annexe 6, la procédure DUAL4 se distingue essentiellement en Ph602 où il est différemment testé si le transistor TrN a son drain et sa source raccordés en N1 et au noeud Inc d'un réseau RN1 et si le transistor TrP a son drain et sa source raccordés en P1 et au noeud Jnc d'un réseau RP2. Ce cas correspond à celui de la figure 10. Dans ce cas, il faut que le réseau RN1 soit le dual d'un réseau RP1 raccordé en P1 et au noeud Jnc. Cette condition se traduit par l'appel récursif de la fonction CMOS DUAL, dans laquelle la variable P2 est instanciée à la valeur du noeud Jnc et N1 instancié à la valeur du noeud Inc. Dans ce cas, il faut encore que RP2 soit le dual d'un réseau RN2 raccordé en N1 et N2. Cette condition se traduit par l'appel récursif de la fonction CMOS DUAL, dans lequel la variable P1 est instanciée à la valeur du noeud Jnc. En Ph603, la variable Equation est instanciée à la conjonction de l'équation Q2 et de la disjonction du signal en G et de l'équation Q1, où Q1 et Q2 sont les équations retournées par les appels récursifs de CMOS DUAL satisfaisant les conditions de Ph602.

Comme nous le voyons en annexe 7, la procédure DUAL5 se distingue essentiellement en Ph702 où il est différemment testé si le transistor TrN a son drain et sa source raccordés en N1 et au noeud Inc d'un réseau RN2 et si le transistor TrP a son drain et sa source raccordés en P1 et au noeud Jnc d'un réseau RP1. Ce cas correspond à celui de la figure 11. Dans ce cas, il faut que le réseau RN2 soit le dual d'un réseau RP2 raccordé en P2 et P1. Cette condition se traduit par l'appel récursif de la fonction CMOS DUAL, dans laquelle la variable N2 est instanciée à la valeur du noeud Inc. Dans ce cas, il faut encore que RP1 soit le dual d'un réseau RN1 raccordé au noeud Inc et en N2. Cette condition se traduit par l'appel récursif de la fonction CMOS DUAL, dans laquelle la variable P2 est instanciée à la valeur du noeud Jnc et N1 est instanciée à la valeur du noeud Inc. En Ph703, la variable Equation est instanciée à la disjonction de l'équation Q2 et de la conjonction du signal en G et de l'équation Q1, où Q1 et Q2 sont les équations retournées par les appels récursifs de CMOS DUAL satisfaisant les conditions de Ph702.

Les procédures que nous venons de décrire associent donc à chaque transistor MOS du circuit une donnée sous forme d'un objet TrN ou TrP, à chaque connexion physique d'un transistor TrN et d'un transistor TrP avec un autre élément concret du circuit sont attribuées des valeurs d'attributs structurels N1,N2,P1,P2 de ces objets OBJE, elles regroupent les objets OBJE ainsi obtenus en objets OBJC dans les phases Ph302, Ph402, Ph502, Ph602, Ph702. Chaque objet OBJC représente un circuit dual constitué des éléments concrets du circuit, associés aux objets OBJE regroupés dans l'objet OBJC. La procédure de recherche associe une valeur d'attribut structurel Sortie, Vss, Vdd de l'objet OBJC à chaque connexion physique d'un élément TrN, TrP avec un élément extérieur au circuit dual représenté par l'objet OBJC. En phase Ph101, la procédure de recherche dote de plus l'objet OBJC d'un attribut fonctionnel EQUATION, dont la valeur est une chaîne de caractères traduisant en langage formel, le comportement fonctionnel du circuit dual associé à l'objet OBJC. Cette chaîne de caractères est générée automatiquement sous forme d'équations logiques Q dans les phases Ph101, Ph303, Ph403, Ph503, Ph603, Ph703.

L'invention vient d'être décrite à l'aide de son application à un système physique particulier constitué d'un circuit électrique de transistors CMOS. D'autres applications sont possibles sans sortir du cadre de la présente invention. On peut citer à titre non limitatif dans le domaine électronique les transistors BICMOS, bipolaires ou As Ga, dans le domaine optronique, les différents types de portes optiques, dans le domaine chimique les molécules avec leurs liaisons au sein d'une macromolécule.

## Annexe 1

## Procédure de recherche

Ph100

tant que SELECTION SIGNAL NP(SORTIE),
réitérer Ph101

Ph101

si CMOS DUAL(G,sortie,vss,sortie,vdd,Q) est vrai,
alors
ENREGISTRER EQUATION( Sortie=nonQ )

## Annexe 2

## Procédure CMOS DUAL(G,P1,P2,N1,N2,Q)

Ph201

si DUAL1(G,P1,P2,N1,N2,Q) est vrai,
alors retourner vrai

Ph202

si DUAL2(G,P1,P2,N1,N2,Q) est vrai,
alors retourner vrai
si DUAL2(G,P1,P2,N2,N1,Q) est vrai,
alors retourner vrai

Ph203

si DUAL3(G,P1,P2,N1,N2,Q) est vrai,
alors retourner vrai
si DUAL3(G,P2,P1,N1,N2,Q) est vrai,
alors retourner vrai

Ph204

si DUAL4(G,P1,P2,N1,N2,Q) est vrai,
alors retourner vrai
si DUAL4(G,P1,P2,N2,N1,Q) est vrai,
alors retourner vrai
si DUAL4(G,P2,P1,N1,N2,Q) est vrai,
alors retourner vrai
si DUAL4(G,P2,P1,N2,N1,Q) est vrai,
alors retourner vrai

Ph205

si DUAL5(G,P1,P2,N1,N2,Q) est vrai,
alors retourner vrai
si DUAL5(G,P1,P2,N2,N1,Q) est vrai,
alors retourner vrai
si DUAL5(G,P2,P1,N1,N2,Q) est vrai,
alors retourner vrai
si DUAL5(G,P2,P1,N2,N1,Q) est vrai,
alors retourner vrai

Ph206

sinon retourner faux

## Annexe 3

### Procédure DUAL1(G,P1,P2,N1,N2,Equation)

Ph300

MEMORISER (G,P1,P2,N1,N2)

Ph301

tant que REFERENCE MOS(G,TrN,TrP),
réitérer Ph302,
terminer en Ph305

Ph302

si MOSN(G,N1,N2,TrN) est vrai
et MOSP(G,P1,P2,TrP) est vrai
alors Ph303
sinon Ph304

Ph303

Equation = G
retourner vrai

Ph304

RESTAURER (TrN,TrP)
REMETTRE (G,P1,P2,N1,N2)

Ph305

retourner faux

## Annexe 4

## Procédure DUAL2(G,P1,P2,N1,N2,Equation)

Ph400

MEMORISER (G,P1,P2,N1,N2,Inc,Q)

Ph401

tant que REFERENCE MOS(G,TrN,TrP),
réitérer Ph402,
terminer en Ph405

Ph402

si MOSP(G,P1,P2,TrP) est vrai
et MOSN(G,N1,Inc,TrN) est vrai
et CMOS DUAL (G1,P1,P2,Inc,N2,Q) est vrai
alors Ph403
sinon Ph404

Ph403

Equation = G et Q
retourner vrai

Ph404

RESTAURER (TrN,TrP)
REMETTRE (G,P1,P2,N1,N2,Inc,Q)

Ph405

retourner faux

## Annexe 5

## Procédure DUAL3(G,P1,P2,N1,N2,Equation)

Ph500

MEMORISER (G,P1,P2,N1,N2,Jnc,Q)

Ph501

tant que REFERENCE MOS(G,TrN,TrP),
réitérer Ph502,
terminer en Ph505

Ph502

si MOSN(G,N1,N2,TrN) est vrai
et MOSP(G,P1,Jnc,TrP) est vrai
et CMOS DUAL (G1,Jnc,P2,N1,N2,Q) est vrai
alors Ph503
sinon Ph504

Ph503

Equation = G ou Q
retourner vrai

Ph504

RESTAURER (TrN,TrP)
REMETTRE (G,P1,P2,N1,N2,Jnc,Q)

Ph505

retourner faux

## Annexe 6

## Procédure DUAL4(G,P1,P2,N1,N2,Equation)

Ph600

MEMORISER (G,P1,P2,N1,N2,Inc,Jnc,Q1,Q2)

Ph601

tant que REFERENCE MOS(G,TrN,TrP),
réitérer Ph602,
terminer en Ph605

Ph602

si MOSN(G,N1,Inc,TrN) est vrai
et MOSP(G,P1,Jnc,TrP) est vrai
et CMOS DUAL (G1,P1,Jnc,Inc,N2,Q1) est vrai
et CMOS DUAL (G2,Jnc,P2,N1,N2,Q2) est vrai
alors Ph603
sinon Ph604

Ph603

Equation = (G et Q1) ou Q2
retourner vrai

Ph604

RESTAURER (TrN,TrP)
REMETTRE (G,P1,P2,N1,N2,Inc,Jnc,Q1,Q2)

Ph605

retourner faux

## Annexe 7

### Procédure DUAL5(G,P1,P2,N1,N2,Equation)

Ph700

MEMORISER (G,P1,P2,N1,N2,Inc,Jnc,Q1,Q2)

Ph701

tant que REFERENCE MOS(G,TrN,TrP),
réitérer Ph702,
terminer en Ph705

Ph702

si MOSN(G,Inc,N2,TrN) est vrai
et MOSP(G,Jnc,P2,TrP) est vrai
et CMOS DUAL (G1,P1,Jnc,N1,Inc,Q1) est vrai
et CMOS DUAL (G2,P1,P2,Inc,N2,Q2) est vrai
alors Ph703
sinon Ph704

Ph703

Equation = (G ou Q1) et Q2
retourner vrai

Ph704

RESTAURER (TrN,TrP)
REMETTRE (G,P1,P2,N1,N2,Inc,Jnc,Q1,Q2)

Ph705

retourner faux

**Revendications**

1.  Outil (OA) produisant automatiquement, suivant des procédures programmées, une spécification abstraite (SPECRET) définissant le comportement fonctionnel d'un système physique (SYSPHY) à partir d'un descriptif concret (DESCONC) définissant la structure de ce système,
    caractérisé en ce qu'il comprend

    -   des moyens pour associer à des éléments du descriptif concret des données sous forme d'objets (OBJE),

    -   des moyens pour associer aux connexions physiques de ces éléments avec d'autres éléments du descriptif concret, des valeurs d'attribut structurel de ces objets (OBJE),

- des moyens pour regrouper les objets (OBJE) ainsi obtenus en objets (OBJC), chaque objet (OBJC) représentant un composant physique constitué des éléments du descriptif concret associés aux objets (OBJE) regroupés dans l'objet (OBJC),

- des moyens pour associer des valeurs d'attribut structurel de l'objet (OBJC) aux connexions physiques avec des éléments extérieurs au composant physique représenté par l'objet (OBJC),

- des moyens pour doter de plus l'objet (OBJC) d'un attribut fonctionnel dont la valeur est une chaîne de caractères traduisant en langage formel, le comportement fonctionnel du composant physique associé à l'objet (OBJC),

- des moyens pour réutiliser, de façon automatique les moyens précédemment décrits, en remplaçant les objets (OBJE) et (OBJC) regroupés par des nouveaux objets (OBJC), et ceci jusqu'à ne plus pouvoir regrouper d'objets de type (OBJE) ou (OBJC),

- et des moyens pour concatèner les valeurs d'attributs fonctionnels des objets (OBJC) résultant pour produire la spécification abstraite (SPECRET) définissant le comportement fonctionnel du système (SYSPHY).

2. Outil (OA) produisant automatiquement, suivant des procédures programmées, une spécification abstraite (SPECRET) définissant le comportement fonctionnel d'un système physique (SYSPHY) à partir d'un descriptif concret (DESCONC) définissant la structure de ce système,
caractérisé en ce qu'il comprend

- des moyens pour associer à chaque élément concret de cette structure une donnée sous forme d'objet (OBJE),

- des moyens pour associer à chaque connexion physique de cet élément avec un autre élément concret de la structure, une valeur d'attribut structurel de cet objet (OBJE),

- des moyens pour regrouper à l'aide de règles (REG) les objets (OBJE) ainsi obtenus en objets (OBJC), chaque objet (OBJC) représentant un composant physique constitué des éléments concrets de la structure, associés aux objets (OBJE) regroupés dans l'objet (OBJC),

- des moyens pour associer à l'aide de ces même règles (REG), une valeur d'attribut structurel de l'objet (OBJC) à chaque connexion physique d'un élément avec un élément extérieur au composant physique représenté par l'objet (OBJC),

- ainsi que des moyens pour doter à l'aide de ces même règles (REG), l'objet (OBJC) d'un attribut fonctionnel dont la valeur est une chaine de caractères traduisant en langage formel, le comportement fonctionnel du composant physique représenté par l'objet (OBJC),

- des moyens actionnant, de façon automatique les moyens précédemment décrits jusqu'à épuisement des règles, en remplaçant les objets (OBJE) regroupés par les objets (OBJC), ces derniers étant alors considérés comme nouveaux objets (OBJE),

- et des moyens pour concatèner les valeurs d'attributs fonctionnels des objets (OBJE) restant pour produire la spécification abstraite (SPECRET) définissant le comportement fonctionnel du système (SYSPHY).

3. Outil (OA) produisant automatiquement, suivant des procédures programmées, une spécification abstraite (SPECRET) définissant le comportement fonctionnel d'un système physique (SYSPHY) à partir d'un descriptif concret (DESCONC) définissant la structure de ce système, suivant la revendication 2, caractérisé en ce que
les règles (REG) sont des données externes présentées avec le formalisme d'un langage orienté objets, les structures visibles d'une règle étant analogiquement équivalentes aux structures internes telles qu'elles sont manipulées, en tant qu'objets, par les procédures programmées.

4. Outil (OA) produisant automatiquement, suivant des procédures programmées, une spécification abstraite (SPECRET) définissant le comportement fonctionnel d'un système physique (SYSPHY) à partir d'un descriptif concret (DESCONC) définissant la structure de ce système, suivant la revendication 3, caractérisé en ce que,
l'un au moins des moyens pour regrouper les objets (OBJE) en objets (OBJC) à l'aide de règles (REG), est un dispositif de filtrage sélectionnant à partir de chaque règle des objets (OBJE) en mettant en oeuvre des mécanismes d'essaiserreurs avec retour arrière sur les objets (OBJE) satisfaisant à priori cette règle.

**5.** Outil (OA) produisant automatiquement, suivant des procédures programmées, une spécification abstraite (SPECRET) définissant le comportement fonctionnel d'un système physique (SYSPHY) à partir d'un descriptif concret (DESCONC) définissant la structure de ce système, suivant la revendication 3 ou 4, caractérisé en ce que,
la partie conditionnelle d'une règle (REG) comporte un modèle constitué de la combinaison d'objets (OBJM) dont certaines valeurs d'attributs sont des variables initialement libres, le système physique étant constitué d'une combinaison d'objets (OBJE) dont les valeurs d'attributs sont des constantes, les variables sont instanciées aux constantes pour les attributs des objets (OBJM) détectés équivalents aux attributs des objets (OBJE) par le dispositif de filtrage, les valeurs ainsi obtenues sont propagées dans l'ensemble de la règle par un mécanisme d'unification des variables.

**6.** Outil (OA) produisant automatiquement, suivant des procédures programmées, une spécification abstraite (SPECRET) définissant le comportement fonctionnel d'un système physique (SYSPHY) à partir d'un descriptif concret (DESCONC) définissant la structure de ce système, suivant la revendication 1, caractérisé en ce qu'il comprend

- des moyens pour regrouper des ensembles (NSMBL) d'objets (OBJE) en objets (OBJC), à l'aide de fonctions programmées, par adjonction, pour chaque objet (OBJC) d'un ensemble (NSMBL) d'un ou plusieurs objets (OBJCR) constitués des autres ensembles (NSMBL) de l'objet (OBJC), cette adjonction étant conditionnée par une propriété (PRPRT) d'agencement structurel commune aux ensembles (NSMBL), à l'objet (OBJC) et à chaque objet (OBJCR),

- et des moyens pour doter l'objet (OBJC) d'un attribut fonctionnel dont la valeur est une fonction du ou des objets (OBJCR), cette fonction étant déterminée par la propriété (PRPRT).

**7.** Outil (OA) produisant automatiquement, suivant des procédures programmées, une spécification abstraite (SPECRET) définissant le comportement fonctionnel d'un système physique (SYSPHY) à partir d'un descriptif concret (DESCONC) définissant la structure de ce système, suivant l'une des revendications précédentes, caractérisé en ce qu'il est utilisé par un outil de construction de règles (GND2GRD) pour générer automatiquement un modèle (OBJM) d'un composant physique à partir de sa structure et la description formelle du comportement fonctionnel de ce composant en soumettant sa structure au traitement de l'outil (OA), le modèle (OBJM) et la description formelle permettant d'élaborer une règle (REG) de production d'objets (OBJC) associés à un tel composant.

**8.** Outil (OA) produisant automatiquement, suivant des procédures programmées, une spécification abstraite (SPECRET) définissant le comportement fonctionnel d'un système physique (SYSPHY) à partir d'un descriptif concret (DESCONC) définissant la structure de ce système, suivant l'une des revendications précédentes, caractérisé en ce qu'il est utilisé dans la chaîne de retour d'un procédé de réalisation du système (SYSPHY) pour vérifier la conformité du système réalisé à partir d'une spécification fonctionnelle abstraite en comparant la description formelle produite à cette spécification fonctionnelle abstraite.

**9.** Outil (OA) produisant automatiquement, suivant des procédures programmées, une spécification abstraite (SPECRET) définissant le comportement fonctionnel d'un système physique (SYSPHY) à partir d'un descriptif concret (DESCONC) définissant la structure de ce système, suivant l'une des revendications précédentes, caractérisé en ce que le système (SYSPHY) est un circuit électrique.

**10.** Outil (OA) produisant automatiquement, suivant des procédures programmées, une spécification abstraite (SPECRET) définissant le comportement fonctionnel d'un système physique (SYSPHY) à partir d'un descriptif concret (DESCONC) définissant la structure de ce système, suivant la revendication 6, caractérisé en ce que

- un ensemble (NSMBL) représentant le couple d'un transistor (NMOS) et d'un transistor (PMOS) dont les grilles sont reliées en un point commun,

- la propriété (PRPRT) étant qu'un objet (OBJCR) représente un circuit composé de deux circuits duaux,

- la valeur de l'attribut fonctionnel de l'objet (OBJC) est définie par une combinaison logique du signal de grille des transistors (NMOS) et (PMOS) et des valeurs d'attributs fonctionnels des objets (OBJCR).

**11.** Procédé de réalisation d'un système physique SYSPHY comportant une phase de report dans la matière dont est constitué ledit système physique, d'un ensemble structuré d'éléments défini par un descriptif concret DESCONC dudit système physique, caractérisé en ce que ladite phase de report dans la matière est précédée par une première phase établissant une spécification abstraite SPECRET du dit système physique SYSPHY et par une deuxième phase évaluant la spécification abstraite SPECRET établie,
ladite première phase consistant à

- associer aux éléments définis par le descriptif concret DESCONC des données sous forme d'objets OBJE,

- associer aux connexions physiques de ces éléments avec d'autres éléments définis par le descriptif concret DESCONC, des valeurs d'attribut structurel de ces objets OBJE,

- regrouper les objets OBJE ainsi obtenus en objets OBJC, chaque objet OBJC représentant un composant physique constitué d'éléments définis par le descriptif concret DESCONC, auxquels sont associés les objets OBJE regroupés dans l'objet OBJC,

- associer une valeur d'attribut structurel de l'objet OBJC à chaque connexion physique de chacun de ses éléments avec un élément extérieur au composant physique représenté par l'objet OBJC,

- doter de plus l'objet OBJC d'un attribut fonctionnel dont la valeur est une chaîne de caractères traduisant en langage formel, le comportement fonctionnel du composant physique associé à l'objet OBJC,

- réitérer, de façon automatique la procédure précédemment décrite de la première phase, en prenant pour objets OBJE, les objets OBJC précédemment obtenus, et ceci jusqu'à ne plus pouvoir regrouper d'objets OBJE ou OBJC,

- enfin concaténer les valeurs d'attributs fonctionnels des objets OBJC résultants, produisant ainsi la spécification abstraite SPECRET.

**12.** Procédé de réalisation d'un système physique SYSPHY suivant la revendication 11, caractérisé en ce que,

- possédant une spécification abstraite initiale SPECINIT, le descriptif concret DESCONC est obtenu au moyen d'un outil de conception assisté par ordinateur CAO, et en ce que,

- la deuxième phase évalue la spécification abstraite SPECRET au moyen d'un outil d'évaluation COMP qui détecte si les spécifications abstraites SPECRET et SPECINIT sont identiques, pour autoriser la phase de report dans la matière de l'ensemble structuré d'éléments défini par le descriptif concret DESCONC s'il détecte que les spécifications abstraites SPECRET et SPECINIT sont identiques.

**13.** Procédé de réalisation d'un système physique SYSPHY suivant la revendication 11, caractérisé en ce que, possédant un descriptif concret DESCONC,

- la deuxième phase évalue la spécification abstraite SPECRET au moyen d'un outil d'évaluation ACTUAL qui permet de modifier la spécification abstraite SPECRET pour en faire une spécification abstraite initiale SPECINIT,

- un nouveau descriptif concret DESCONC est obtenu au moyen d'un outil de conception assisté par ordinateur CAO pour obtenir un nouveau système physique SYSPHY par report dans la matière de l'ensemble structuré d'éléments défini par le nouveau descriptif concret DESCONC.

## FIGURE 1

## FIGURE 2

**FIGURE 3**

## FIGURE 4

# FIGURE 5

# FIGURE 6

**VDD**

**RESEAU MOS P**

**SORTIE**

**RESEAU MOS N**

**VSS**

## FIGURE 7

TrP

P2

MOSP(G,P1,P2,TrP)

G

P1

N1

MOSN(G,N1,N2,TrN)

N2

TrN

## FIGURE 8

TrP

P2

G

RP

P1

N1

Inc

TrN

RN

N2

N1 et N2
permutables

## FIGURE 9

## FIGURE 10

## FIGURE 11

TrP

P2

RP2

Jnc

RP1

P1

P1 et P2
permutables

N1

RN2

Inc

RN1

N1 et N2
permutables

G

N2

TrN

Office européen
des brevets

**RAPPORT DE RECHERCHE EUROPEENNE**

Numero de la demande
EP 95 40 1930

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | PROCEEDINGS OF THE EUROPEAN CONFERENCE ON DESIGN AUTOMATION, 16 Mars 1992, BRUSSELS BE, pages 458-462, XP002000245 DEVERCHERE ET AL: "functional abstraction and formal proof of digital circuits" * le document en entier * --- | 1-13 | G06F17/50 |
| A | IEEE JOURNAL OF SOLID-STATE CIRCUITS., vol. 26, no. 3, Mars 1991, NEW YORK US, pages 394-402, XP002000246 KOSTELIJK ET AL: "automatic verification of library-based ic designs" * page 396, colonne 2, ligne 25 - page 398, colonne 2, ligne 2; figures 4,5 * ----- | 1-13 | |

**DOMAINES TECHNIQUES RECHERCHES (Int.Cl.6)**

G06F

Le présent rapport a été établi pour toutes les revendications

| Lieu de la recherche | Date d'achèvement de la recherche | Examinateur |
|---|---|---|
| LA HAYE | 1 Décembre 1995 | Guingale, A |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)